# EUROPÄISCHE PATENTSCHRIFT

(11) **EP 3 244 221 B1**
(45) Veröffentlichungstag und Bekanntmachung des Hinweises auf die Patenterteilung: **04.08.2021**
(21) Anmeldenummer: 16169111.8
(22) Anmeldetag: 11.05.2016
(51) Int. Cl.: G01R 31/52, H01H 47/00, G01R 31/327, G01R 31/28

(54) **ÜBERWACHUNGSANORDNUNG ZUR ÜBERWACHUNG EINES SICHERHEITSGEBERS UND VERFAHREN ZUR ÜBERWACHUNG EINES SICHERHEITSGEBERS**
MONITORING ASSEMBLY FOR MONITORING A SECURITY SENSOR AND METHOD FOR MONITORING A SECURITY SENSOR
SYSTEME DE SURVEILLANCE D'UN CAPTEUR DE SECURITE ET PROCEDE DE SURVEILLANCE D'UN CAPTEUR DE SECURITE

(43) Veröffentlichungstag der Anmeldung: 15.11.2017
(73) Patentinhaber: TRUMPF Schweiz AG, 7214 Grüsch (CH)
(72) Erfinder: Hürlimann, Thomas, 7310 Bad Ragaz (CH)
(74) Vertreter: Kohler Schmid Möbus Patentanwälte

(56) Entgegenhaltungen:
- EP-A1- 1 811 591
- DE-A1- 19 702 009
- DE-A1-102007 003 306
- DE-A1-102009 031 040
- DE-A1-102012 101 516
- DE-A1-102013 101 314
- DE-A1-102013 101 932
- DE-A1-102013 106 487
- DE-A1-102014 219 235
- DE-B3-102005 055 325
- US-A1- 2012 299 578
- US-A1- 2013 320 906
- US-A1- 2015 162 747
- KAI FENG ET AL: "Dual Power Automatic Switch Device Design", CONTROL ENGINEERING AND COMMUNICATION TECHNOLOGY (ICCECT), 2012 INTERNATIONAL CONFERENCE ON, IEEE, 7. Dezember 2012 (2012-12-07), Seiten 72-74, XP032311254, DOI: 10.1109/ICCECT.2012.128 ISBN: 978-1-4673-4499-9
- None

## Beschreibung

Die Erfindung betrifft eine Überwachungsanordnung zur Überwachung eines Sicherheitsgebers, umfassend
a. eine erste elektrische Versorgungsquelle, die mit einem Eingangsanschluss zum Anschluss eines Eingangs des Sicherheitsgebers verbunden ist,
b. eine erste ausgangsseitige Messeinrichtung, die mit einem Ausgangsanschluss zum Anschluss eines Ausgangs des Sicherheitsgebers verbunden ist,
c. eine Auswerteanordnung, die mit der ersten ausgangsseitigen Messeinrichtung verbunden ist und deren Messsignal erhält, und
d. eine erste eingangsseitige Messeinrichtung, die mit dem Eingangsanschluss und der Auswerteanordnung verbunden ist, wobei die Auswerteanordnung das Messsignal der ersten eingangsseitigen Messeinrichtung erhält und eingerichtet ist, die Messsignale auszuwerten.

Weiterhin betrifft die Erfindung ein Verfahren zur Überwachung eines Sicherheitsgebers.

Zur Stellungsüberwachung von Schutzgittern, Schutztüren, Maschinenverkleidungsteilen oder anderen Schutzeinrichtungen, die den Zugang zu gefährlichen Maschinenteilen oder anderen Gefahrenstellen sichern, sind Sicherheitsgeber vorgeschrieben, die ein Öffnen der Schutzeinrichtung erkennen und Gefährdungen steuerungstechnisch, beispielsweise durch Abschalten der Maschine, verhindern. Üblicherweise sind die Sicherheitsgeber ortsfest nahe der Schutzeinrichtung angeordnet. Als Sicherheitsgeber kommen beispielsweise Sicherheitsschalter in Frage. Wird beispielsweise detektiert, dass ein Sicherheitsgeber geöffnet ist, so kann dies darauf hindeuten, dass die Schutzreinrichtung geöffnet ist und dass die von der Schutzeinrichtung zumindest teilweise umgebene Maschine in einen sicheren Zustand gebracht werden muss. Sichere Zustände können z.B. sein: überwachter Zustand, kontrollierter Halt, reduziertes Drehmoment, reduzierte Geschwindigkeit, sichere Bewegungsrichtung. Unterbrechung eines Laserstrahls durch einen optomechanischen oder optoelektrischen Shutter oder Abschaltung.

In der Regel sind mehrere Sicherheitsgeber vorgesehen. Zur Detektion eines gefährlichen Zustands muss außerdem erkannt werden können, ob ein Querschluss vorliegt, d.h. ein Kurzschluss zwischen Leitungen, an die Sicherheitsgeber angeschlossen sind.

Aus der DE 197 02 009 A1 ist eine Überwachungseinrichtung mit Überwachungsschaltern bekannt, die jeweils an eine elektrische Versorgungsquelle angeschlossen und mit mindestens einer auf den jeweiligen Schalterausgang ansprechenden Auswerteeinheit gekoppelt sind. Zur Querschlussüberwachung ist vorgesehen, dass die Spannungsversorgung von mindestens einem Überwachungsschalter jeder Gruppe über jeweils einen Taktgeber getaktet ist, wobei die Auswerteeinheit die durch den entsprechenden Taktgeber bewirkte Potentialänderung des Ausgangs des getakteten geschlossenen Überwachungsschalters und den gleichzeitig auf Spannung liegenden Ausgang des wenigstens einen weiteren Überwachungsschalters überprüft.

Aus der US 2013/0320906 A1 ist ein elektrisches Servolenk-System bekannt, bei dem die Eingangs- und Ausgangsspannung eines Sicherheitsschalters überwacht wird.

Die DE 10 2013 101 314 A1 betrifft eine Photovoltaikanlage mit zumindest einem Strang aus Solarmodulen und einem System zum einzelnen Freischalten der Solarmodule und zum sicheren erstmaligen Anschalten oder Wiederanschalten der freigeschalteten Solarmodule an den Strang. Die Solaranschlussdosen weisen eine Sicherheitsschaltung auf, die einen Betriebszustand und einen Sicherheitszustand definiert.

Die EP 1 811 591 A1 betrifft eine Batterie mit mehreren in Serie und/oder parallel geschalteten Batteriezellen und zwei Batteriepolen, wobei eine Sicherheitsschaltung vorgesehen ist, welche einen Widerstand aufweist, der in die stromleitende Verbindung zwischen den Batteriezellen und einem der Batteriepole schaltbar ist.

Aus der DE 10 2014 219 235 A1 ist eine Schaltungsvorrichtung zum Ermitteln eines Zustands einer elektrischen Verriegelungsleiterschleife zur Überwachung einer Hochvolt-Komponente bekannt.

Aufgabe der vorliegenden Erfindung ist es, eine Überwachungsanordnung und ein Verfahren zur Überwachung eines Sicherheitsgebers anzugeben, mit denen eine zuverlässigere Detektion des Zustands des Sicherheitsgebers und von Querschlüssen ermöglicht wird.

Gelöst wird diese Aufgabe erfindungsgemäß durch eine Überwachungsanordnung mit den Merkmalen des Anspruchs 1.

Dabei kann die Auswerteanordnung insbesondere eingerichtet sein, zu erkennen, ob der Sicherheitsgeber geöffnet oder geschlossen ist oder ob ein Querschluss vorliegt. Dadurch, dass nicht nur ausgangsseitig des Sicherheitsgebers ein Messsignal erfasst wird, sondern auch am Eingangsanschluss des Sicherheitsgebers ein Messsignal erfasst wird, kann zuverlässiger und schneller erkannt werden, ob der Sicherheitsgeber geöffnet oder geschlossen ist oder ein Querschluss vorliegt. Insbesondere die Detektion einer Öffnung des Sicherheitsgebers kann schnell erkannt werden wegen einer geringen Latenzzeit durch sofort eindeutige Signalzustände.

Besondere Vorteile ergeben sich, wenn die elektrische Versorgungsquelle als insbesondere gesteuerte Stromquelle ausgebildet ist. Eine Stromquelle kann einen bestimmten Strom über den Sicherheitsgeber fliesen lassen. Dieser Strom wird über einen Widerstand, der vorzugsweise an dem Ausgangsanschluss angeschlossen ist, gegen Erde geleitet, was zu einem stromabhängigen Spannungsabfall über dem Widerstand führt. Bei geschlossenem Sicherheitsgeber wird sowohl am Eingang als auch am Ausgang des Sicherheitsgebers, d.h. am Eingangsanschluss und am Ausgangsanschluss, im Wesentlichen die gleiche Spannung gemessen. Bei geöffnetem Sicherheitsgeber liegt am Eingang des Sicherheitsgebers eine größere Spannung, insbesondere eine Versorgungsspannung der Stromquelle, an als am Ausgang des Sicherheitsgebers. Wird dies erkannt, wird das durch die Überwachungsanordnung zu überwachende System in einen sicheren Zustand gebracht, zum Beispiel abgeschaltet.

Eine Steuereinrichtung ist zur Beeinflussung einer am Ausgangsanschluss messbaren elektrischen Größe vorgesehen. Insbesondere kann damit ein Querschluss erkannt werden. Dabei kann die Steuereinrichtung in die elektrische Versorgungsquelle integriert sein. Insbesondere kann die Versorgungsquelle als steuerbare Stromquelle ausgebildet sein. Der von der Versorgungsquelle ausgegebene Strom kann moduliert werden. Insbesondere kann er amplituden-oder frequenzmoduliert werden. Beispielsweise kann der Strom im Takt eines vorgegebenen Pulsmusters ausgegeben werden.

Alternativ kann die Steuereinrichtung einen Widerstand und parallel dazu einen steuerbaren Schalter aufweisen, durch den der Widerstand überbrückt werden kann. Je nach Schalterzustand ändert sich die über dem Widerstand abfallende Spannung, z.B. im Takt eines Pulsmusters oder eines Modulationssignals, mit dem der Schalter angesteuert wird. Liegt bei geschlossenem Sicherheitsgeber kein Querschluss vor, so unterscheiden sich die am Eingang und Ausgang des Sicherheitsgebers gemessenen Spannungen nur um einen Spannungsabfall über dem Sicherheitsgeber, also nur geringfügig. Liegt dagegen ein Querschluss von einem Sicherheitsgeber zu einem anderen gleichartig überwachten Sicherheitsgeber vor, entstehen größere Spannungsunterschiede, die zum Abschalten des überwachten Systems bzw. der Maschine, deren Schutzvorrichtung durch die Überwachungsanordnung überwacht wird, genutzt werden können. Sind mehrere Sicherheitsgeber geschlossen und besteht ein Querschluss, entstehen Spannungsunterschiede gegenüber den erwarteten Spannungen an den Messstellen, insbesondere an den Ausgangsanschlüssen.

Die Steuereinrichtung kann mit der Auswerteanordnung verbunden und von dieser gesteuert sein. Somit ist der Auswerteanordnung bekannt, welche Signalbeeinflussung die Steuereinrichtung vornimmt, insbesondere welchen Strom die gesteuerte Stromquelle ausgibt, und kann dies bei der Auswertung der gemessenen Signale berücksichtigen.

Die Auswerteanordnung umfasst einen Modulationssignalgenerator, mit dessen Modulationssignal die Steuereinrichtung, insbesondere die elektrische Versorgungsquelle oder der überbrückende Schalter, angesteuert wird. Beispielsweise kann der Modulationssignalgenerator ein Modulationssignal erzeugen, das eine Frequenzmodulation oder eine Amplitudenmodulation des von der Versorgungsquelle ausgegebenen Stroms bewirkt. Die Vorgabe eines (digitalen) Pulsmusters wird im Sinne der Erfindung als Amplitudenmodulation des Stromsignals verstanden. Insbesondere kann ein gepulster Strom durch die Versorgungsquelle ausgegeben werden oder der Widerstand durch den Schalter gepulst überbrückt werden. Alternativ kann ein sich innerhalb bestimmter Werte kontinuierlich ändernder Strom ausgegeben werden.

Besondere Vorteile ergeben sich, wenn die Auswerteanordnung einen ersten Mikroprozessor aufweist, der die Messsignale erhält und diese auswertet. Durch einen Mikroprozessor kann auf besonders einfache und schnelle Art und Weise ein Vergleich der Messsignale durchgeführt und können entsprechend die Messsignale ausgewertet werden. Somit kann besonders schnell erkannt werden, ob der Sicherheitsgeber geöffnet oder geschlossen ist oder ob ein Querschluss vorliegt. Der größte Vorteil für die Schnelligkeit liegt für eine Öffnung des Sicherheitsgebers darin, dass im unsicheren Zustand quasi sofort und nicht erst nach dem nächsten Abfragezyklus oder der Dekodierung des nächsten gelesenen Pulsmusters eindeutige Fehlersignale vorliegen, die zur Fehlerreaktion genutzt werden können. Z.B. ist es möglich innerhalb von 1-3ms einen offenen Sicherheitsgeber zu erkennen. Vorteilhafterweise weist der Mikroprozessor auch den Modulationssignalgenerator auf. Der Mikroprozessor weiss daher, welche Messsignale bei einem störungsfreien Betrieb bzw. fehlerfreien Zustand zu erwarten sind.

Die Auswerteanordnung kann einen zweiten Mikroprozessor aufweisen, der die Messsignale erhält und diese auswertet. Durch die Verwendung eines zweiten Mikroprozessors wird eine Redundanz geschaffen. Somit kann sichergestellt werden, dass ein einzelner Fehler in der Überwachungsanordnung nicht zum Verlust der Sicherheitsfunktion führt. Insbesondere, wenn die Überwachungsanordnung eingesetzt werden soll, um Sicherheitsabdeckungen zu überwachen, die Bediener vor gefährlichen Laserstrahlen schützen, kann durch die Verwendung von zwei Mikroprozessoren sichergestellt werden, dass die Normen ISO13849 Safety of machinery - safety-related parts of control systems und DIN EN ISO 13849-1 Sicherheit von Maschinen - sicherheitsbezogene Teile von Steuerungen, eingehalten werden. Der Ausfall eines der Mikroprozessoren oder ein Fehler in der Verdrahtung kann daher nicht zu einem unsicheren Zustand führen.

Der erste und der zweite Mikroprozessor können datentechnisch, insbesondere über ein Bus-System, miteinander verbunden sein und jeder Mikroprozessor kann das Messsignal einer Messeinrichtung direkt von dieser erhalten und das andere Messsignal indirekt über den jeweils anderen Mikroprozessor und die datentechnische Verbindung erhalten. Somit stehen jedem Mikroprozessor die Messsignale am Eingang und am Ausgang eines Sicherheitsgebers zur Verfügung und er kann unabhängig vom anderen Mikroprozessor einen Vergleich der Messsignale durchführen und auf den Zustand des Sicherheitsgebers schließen.

Der Aufwand der Verdrahtung kann reduziert werden, indem jeder Mikroprozessor nur direkt mit einer Messeinrichtung, die einem zu überwachenden Sicherheitsgeber zugeordnet ist, verbunden ist und das Messsignal der anderen Messeinrichtung, die dem zu überwachenden Sicherheitsgeber zugeordnet ist, über den anderen Mikroprozessor erhält. Über die datentechnische Verbindung können auch die durch den jeweiligen Mikroprozessor ermittelten Vergleichsergebnisse ausgetauscht und verglichen werden. Als datentechnische Verbindung kann insbesondere ein CAN-Bus zum Einsatz kommen.

Besondere Vorteile ergeben sich, wenn zumindest ein weiterer Eingangsanschluss und ein weiterer Ausgangsanschluss zum Anschluss eines weiteren Sicherheitsgebers vorgesehen sind, wobei der zumindest eine weitere Eingangsanschluss mit einer zweiten elektrischen Versorgungsquelle und einer zweiten eingangsseitigen Messeinrichtung und der zumindest eine weitere Ausgangsanschluss mit einer zweiten ausgangsseitigen Messeinrichtung verbunden ist. Somit können mehrere Sicherheitsgeber überwacht werden. Außerdem kann auf einfache Art und Weise ein Querschluss detektiert werden.

Zur Erkennung eines Querschlusses ist es insbesondere vorteilhaft, wenn jede Steuereinrichtung mit einem anderen Modulationssignal angesteuert wird. Werden gesteuerte Stromquellen verwendet, kann jede Stromquelle einen anderen Strom ausgeben. Dabei ist es gleichgültig, ob die Steuereinrichtungen von dem ersten oder dem zweiten Mikroprozessor angesteuert werden. Es ist auch denkbar, dass einmal der eine Mikroprozessor und einmal der andere Mikroprozessor die Steuereinrichtungen ansteuert. Wesentlich ist, dass die von den Steuereinrichtungen ausgegebenen Signale, insbesondere Ströme, unterscheidbar sind. Aus diesem Grund ist es vorteilhaft, wenn ein Mikroprozessor die Zuständigkeit hat, die Modulationssignale für alle Steuereinrichtungen zu erzeugen.

Die Ausgangssignale der Mikroprozessoren können so verschaltet sein, dass wenn nur einer von ihnen ausfällt oder ein Signal sendet, das auf einen Querschluss oder geöffneten Sicherheitsgeber hindeutet, die zu überwachende Maschine in einen sicheren Zustand gebracht wird. Den Messsignalvergleich können beide Mikroprozessoren unabhängig voneinander durchführen. Sie vergleichen jeweils die Spannung der unmittelbar mit dem Mikroprozessor verbundenen Messeinrichtung mit der Spannung, die über den anderen Mikrocontroller und über die datentechnische Verbindung erhalten wird mit der zu erwartenden Sollspannung bzw. die Differenz der Spannungen mit einem vorgegebenen Wert. Die Sollspannung entspricht dabei zum Beispiel dem Produkt aus moduliertem Strom der Versorgungsquelle und dem an dem Ausgangsanschluss angeschlossenen Widerstand.

In den Rahmen der Erfindung fällt außerdem ein Verfahren zur Überwachung eines Sicherheitsgebers mit den Merkmalen des Anspruchs 8.

Mit diesem Verfahren können die oben genannten Vorteile erzielt werden.

Eine bei geschlossenem Sicherheitsgeber am ausgangsseitigen Anschluss messbare elektrische Größe wird moduliert, insbesondere das Versorgungssignal wird moduliert, vorzugsweise amplituden- oder frequenzmoduliert. Dies ist insbesondere dann vorteilhaft, wenn erkannt werden soll, ob ein Querschluss vorliegt. Dabei sollte die Größe, insbesondere das Versorgungssignal, für jeden Sicherheitsgeber anders moduliert werden. Vorteil der gegenwärtigen Erfindung gegenüber der Querschlusserkennung mit reinen Spannungspulsmustern ist, dass trotz der Modulation zur Querschlusserkennung keine Totzeiten für die Erkennung eines offenen Sicherheitsgebers entstehen, da nicht abgewartet werden muss, ob ein Nullsignal Teil des Pulsmusters ist oder durch einen offenen Sicherheitsgeber bedingt. Somit muss die Modulation zur Querschlusserkennung nicht schnell erfolgen, obwohl gleichzeitig ein offener Sicherheitsgeber sehr schnell anhand eindeutiger Signale erkannt werden kann.

Das Versorgungssignal kann durch eine Stromquelle erzeugt werden, wobei die Stromquelle so angesteuert wird, dass der Strom > 0 A ist und die ausgegebene Spannung, insbesondere bei geschlossenem Sicherheitsgeber, unterhalb der Versorgungsspannung liegt. Die maximal von der Stromquelle ausgebbare Spannung ist die Versorgungsspannung der Stromquelle. Diese sollte aber nur im Fehlerfall, also wenn der Sicherheitsgeber geöffnet ist, anliegen. Für die Modulation wählt man den Maximalwert vorzugsweise so, dass die über dem Widerstand gemessenen Spannung im Normalfall (Sicherheitsgeber geschlossen) einen Störabstand zu dieser Versorgungsspannung einhält.

Eine besonders einfache Auswertung ergibt sich, wenn als elektrische Größen Spannungen gemessen werden.

Es kann detektiert werden, dass der Sicherheitsgeber geöffnet ist, wenn am Eingangsanschluss des Sicherheitsgebers eine Versorgungsspannung und am Ausgangsanschluss eine Spannung im Bereich von 0V gemessen wird. Insbesondere kann am Ausgangsanschluss eine Spannung von 0V gemessen werden.

Es kann detektiert werden, dass der Sicherheitsgeber geschlossen ist, wenn die Differenz der am Eingangsanschluss und am Ausgangsanschluss des Sicherheitsgebers gemessenen, insbesondere modulierten, Spannungen kleiner ist als ein vorgegebener erster Wert ist. Insbesondere kann der vorgegebene erste Wert dem zu erwartenden Spannungsabfall über dem Sicherheitsgeber entsprechen. Der vorgegebene erste Wert kann insbesondere im Bereich von 0V vorgegeben werden.

Es kann detektiert werden, dass ein Querschluss vorliegt, wenn die am Ausgangsanschluss des Sicherheitsgebers gemessene Größe, insbesondere modulierte Spannung, von einer erwarteten Größe abweicht. Die erwartete Größe kann dabei anhand des dem jeweils überwachten Sicherheitsgeber zugeordneten Modulationssignals ermittelt werden.

Die Verfahrensschritte a. bis e. können für mehrere Sicherheitsgeber durchgeführt werden, wobei für jeden Sicherheitsgeber ein anderes Modulationssignal verwendet wird. Auf diese Art und Weise kann besonders zuverlässig ein Querschluss erkannt werden.

Weitere Merkmale und Vorteile der Erfindung ergeben sich aus der nachfolgenden detaillierten Beschreibung von Ausführungsbeispielen der Erfindung, anhand der Figuren der Zeichnung, die erfindungswesentliche Einzelheiten zeigt, sowie aus den Ansprüchen. Die dort gezeigten Merkmale sind nicht notwendig maßstäblich zu verstehen und derart dargestellt, dass die erfindungsgemäßen Besonderheiten deutlich sichtbar gemacht werden können. Der Gegenstand, für den Schutz begehrt wird, ist in den Ansprüchen angegeben.

In der schematischen Zeichnung sind Ausführungsbeispiele der Erfindung dargestellt und in der nachfolgenden Beschreibung näher erläutert.

Es zeigen:
- Fig. 1: eine erste Ausführungsform einer Überwachungsanordnung;
- Fig. 2: eine zweite Ausführungsform einer Überwachungsanordnung;
- Fig. 3a bis 3c: Signalverläufe zur Darstellung der Erkennung eines geschlos-senen Sicherheitsgebers;
- Fig. 4a: Signalverläufe zur Erläuterung der Erkennung eines geöffneten
- bis 4c: Sicherheitsgebers;
- Fig. 5: eine Dritte Ausführungsform einer Überwachungsanordnung.

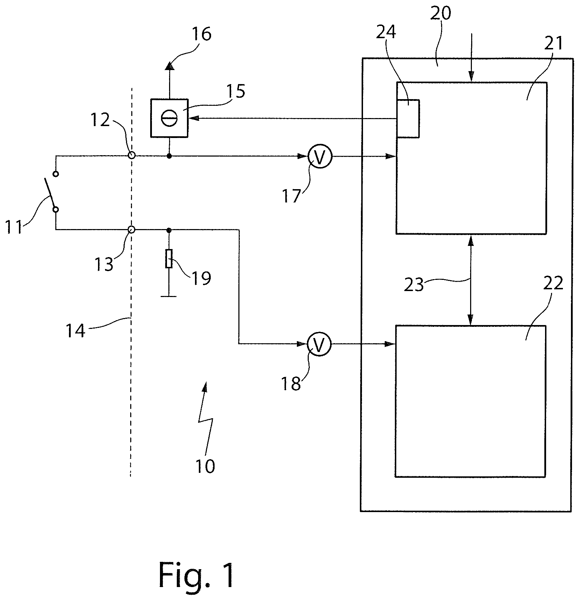

Die Figur 1 zeigt eine Überwachungsanordnung 10 zur Überwachung eines Sicherheitsgebers 11, der im gezeigten Ausführungsbeispiel als Sicherheitsschalter ausgebildet ist. Der Sicherheitsgeber 11 kann mit seinem Eingang an einen Eingangsanschluss 12 und mit seinem Ausgang an einen Ausgangsanschluss 13 der Überwachungsanordnung 10 angeschlossen werden. Die gestrichelte Linie 14 soll die Schnittstelle zu einem Sicherheitsgeber 11 darstellen. An den Eingangsanschluss 12 ist eine als gesteuerte Stromquelle ausgebildete Versorgungsquelle 15 angeschlossen. Diese wiederum ist an eine Versorgungsspannung 16 angeschlossen. An den Eingangsanschluss 12 ist weiterhin eine erste eingangsseitige Messeinrichtung 17 angeschlossen. An den Ausgangsanschluss 13 ist eine erste ausgangsseitige Messeinrichtung 18 angeschlossen. Außerdem ist an den Ausgangsanschluss 13 ein Widerstand 19 angeschlossen. Mit der Messeinrichtung 18 kann somit die Spannung über dem Widerstand 19, die auch am Ausgangsanschluss 13 anliegt, gemessen werden.

Eine Auswerteanordnung 20 umfasst einen ersten Mikroprozessor 21 und einen zweiten Mikroprozessor 22. Der erste Mikroprozessor 21 ist mit der ersten eingangsseitigen Messeinrichtung 17 verbunden und erhält deren Messsignal direkt. Der zweite Mikroprozessor 22 ist mit der ersten ausgangsseitigen Messeinrichtung 18 verbunden und erhält deren Messsignal direkt. Die Mikroprozessoren 21, 22 sind datentechnisch, im gezeigten Ausführungsbeispiel durch ein Bus-System 23, miteinander verbunden. Über das Bus-System 23 erhält der erste Mikroprozessor 21 vom zweiten Mikroprozessor 22 das Messsignal der ersten ausgangsseitigen Messeinrichtung 18 und entsprechend erhält der Mikroprozessor 22 das Messsignal der ersten eingangsseitigen Messeinrichtung 17 über den Mikroprozessor 21.

Der Mikroprozessor 21 und damit die Auswerteanordnung 20 weist einen Modulationssignalgenerator 24 auf, der ein Modulationssignal zur Ansteuerung der Versorgungsquelle 15 bereitstellt. Dadurch wird das von der Versorgungsquelle 15 ausgegebene Versorgungssignal, insbesondere ein Stromsignal, moduliert. In die Versorgungsquelle 15 ist somit eine Steuereinrichtung integriert, die ein Ausgangssignal der Versorgungsquelle 15 beeinflusst und damit eine am Ausgangsanschluss 13 messbare elektrische Größe (bei geschlossenem Sicherheitsgeber 11). Das Modulationssignal kann dabei eine Amplitudenmodulation, eine Frequenzmodulation und/oder die Erzeugung eines gepulsten Stromsignals bewirken.

In den Mikroprozessoren 21, 22 werden die erfassten Messsignale ausgewertet, insbesondere miteinander verglichen. Durch den Vergleich der Messsignale kann erkannt werden, ob der Sicherheitsgeber 11 geöffnet ist, ob er geschlossen ist oder ob ein Querschluss vorliegt.

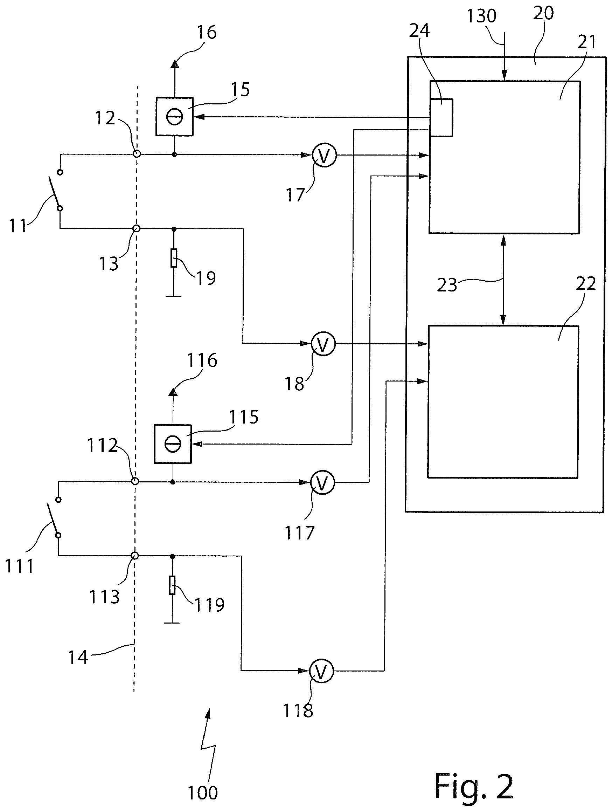

Die Figur 2 zeigt eine weitere Ausführungsform einer Überwachungsanordnung 100. Elemente, die denen der Figur 1 entsprechen, tragen dieselbe Bezugsziffer. Zusätzlich zu den Elementen der Überwachungsanordnung 10 der Figur 1 weist die Überwachungsanordnung 100 der Figur 2 einen weiteren Eingangsanschluss 112 und einen weiteren Ausgangsanschluss 113 zum Anschluss eines weiteren Sicherheitsgebers 111 auf. An den Eingangsanschluss 112 ist eine weitere Versorgungsquelle 115, die an eine Versorgungsspannung 116 angeschlossen ist, angeschlossen. Entsprechend ist an den Eingangsanschluss 112 eine zweite eingangsseitige Messeinrichtung 117 angeschlossen, die ebenfalls mit der Auswerteeinrichtung 20 und dort mit dem ersten Mikroprozessor 21 verbunden ist. An den Ausgangsanschluss 113 ist ebenfalls ein Widerstand 119 angeschlossen, sowie eine zweite ausgangsseitige Messeinrichtung 118, die ebenfalls an die Auswerteanordnung 20 und dort insbesondere an den zweiten Mikroprozessor 22 angeschlossen ist. Dies bedeutet, dass das Signal der zweiten eingangsseitigen Messeinrichtung 117 wiederum über den ersten Mikroprozessor 21 und die Bus-Verbindung 23 an den zweiten Mikroprozessor 22 gelangt und entsprechend das Messsignal der zweiten ausgangsseitigen Messeinrichtung 118 über den Mikroprozessor 21 und die Bus-Verbindung 23 an den Mikroprozessor 22 gelangt.

Die Mikroprozessoren 21, 22 können somit auch die eingangsseitig und ausgangsseitig des Sicherheitsgebers 111 gemessenen Signale miteinander vergleichen und auswerten.

Die Versorgungsquelle 115 ist mit dem Modulationssignalgenerator 24 verbunden. Dabei ist der Modulationssignalgenerator 24 eingerichtet, der Versorgungsquelle 115 ein anderes Modulationssignal zuzuführen als der Versorgungsquelle 15. Dadurch ist es zuverlässiger möglich, einen Querschluss zu detektieren. Es versteht sich, dass den Mikroprozessoren 21, 22 bekannt ist, welche Modulationssignale der Modulationssignalgenerator 24 erzeugt, so dass dies bei der Auswertung der Messsignale berücksichtigt werden kann. Wenn erkannt wird, dass einer der Sicherheitsgeber 11, 111 geöffnet ist oder ein Querschluss vorliegt oder einer der Mikroprozessoren 21, 22 ausgefallen ist, wird die überwachte Maschine durch einen der Mikroprozessoren 21, 22 in einen sicheren Zustand gebracht.

Die Auswerteanordnung 20 ist über ein Bus-System 130 mit einer übergeordneten Steuerung zum Informationsaustausch verbunden.

Es versteht sich, dass die Überwachungsanordnung 100 noch beliebig viele weitere Eingangs- und Ausganganschlüsse mit daran angeschlossenen Versorgungsquellen, Widerständen und Messeinrichtungen, die mit der Auswerteanordnung 20 verbunden sind, zum Anschluss weiterer Sicherheitsgeber aufweisen kann.

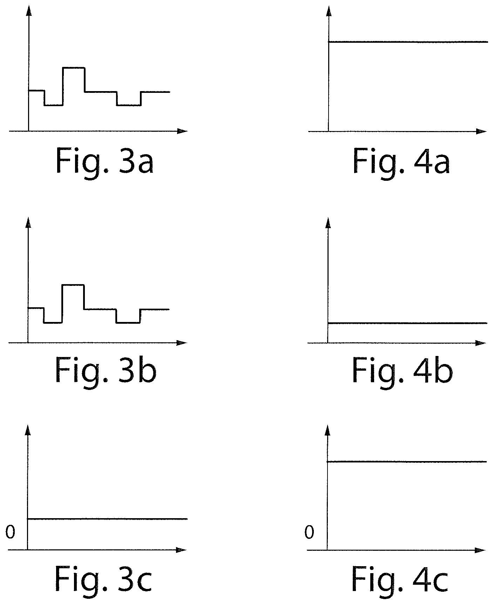

Die Figur 3a zeigt eine Spannung, die durch die Messeinrichtung 17 gemessen wurde. Die Figur 3b zeigt eine Spannung, die durch die Messeinrichtung 18 am Ausgangsanschluss 13 erfasst wurde. Die Figur 3c zeigt die Differenz der Spannungen der Figuren 3a und 3b. Da sowohl am Eingangsanschluss 12 als auch am Ausgangsanschluss 13 nahezu dieselbe Spannung gemessen wurde, ergibt die Differenz nahezu 0V bzw. den Spannungsabfall über dem Sicherheitsgeber. Dies spricht dafür, dass der Sicherheitsgeber 11 geschlossen ist und kein Querschluss vorliegt. Die Spannungen der Figuren 3a, 3b stellen sich aufgrund eines gepulsten Stromsignals der Versorgungsquelle 15 am Widerstand 19 ein. Das Signal der Figur 3b wird für das verwendete Modulationssignal erwartet. Wird eine andere Signalform gemessen, kann dies auf einen Querschluss hindeuten.

Die Figur 4a zeigt wiederum das Signal, das am Eingangsanschluss 12 durch die Messeinrichtung 17 gemessen wurde. Dieses Signal entspricht der Versorgungsspannung 16 der Versorgungsquelle 15. In diesem Fall wird entsprechend der Figur 4b am Ausgangsanschluss 13 jedoch keine Spannung detektiert. Die sich ergebende Differenz, die in der Figur 4c dargestellt ist, entspricht dem Signal der Figur 4a. Die gemessene Spannung ist somit ungleich 0V, was dafür spricht, dass der Sicherheitsgeber 11 geöffnet ist. Am Widerstand 19 ist keine Spannung abgefallen.

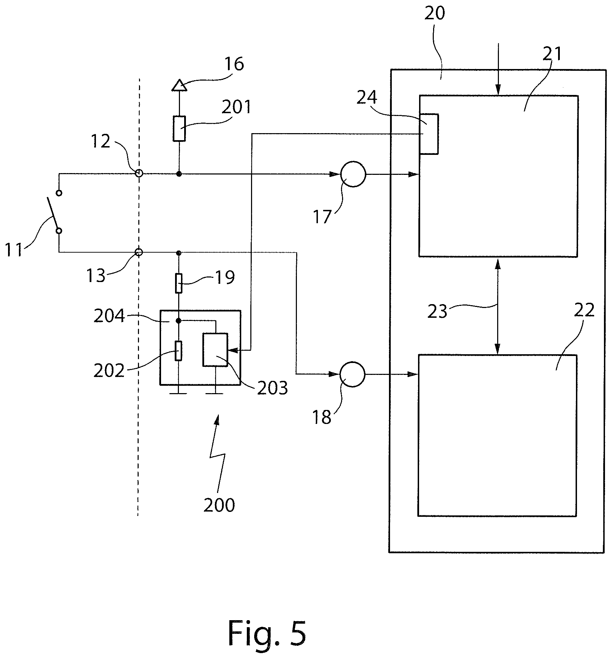

Die Figur 5 zeigt eine weitere Ausführungsform einer Überwachungsanordnung 200. Elemente, die denen der Figur 1 entsprechen, tragen dieselbe Bezugsziffer. Bei der Überwachungsanordnung der Figur 5 ist die Versorgungsspannung 16 über einen Widerstand 201 an den Eingangsanschluss 12 angeschlossen. Die Versorgungsspannung 16 und der Widerstand 201 bilden in diesem Fall die Versorgungsquelle.

In Serie zu dem Widerstand 19 ist ein weiterer Widerstand 202 angeordnet. Parallel zu dem Widerstand 202 ist ein Schalter 203 angeordnet, durch den der Widerstand 202 überbrückbar ist. Der Widerstand 202 und der Schalter 204 bilden eine Steuereinrichtung 204. Die Steuereinrichtung 204 und dort der Schalter 203 werden durch den Modulationssignalgenerator 24 angesteuert. Wird demnach der Schalter 203 leitend geschaltet, so sinkt die am Ausgangsanschluss 13 gemessene Spannung. Durch die Steuereinrichtung 204 kann die durch die Messeinrichtung 18 gemessene Größe somit beeinflusst werden.

## Patentansprüche

1. Überwachungsanordnung (10, 100, 200) zur Überwachung eines Sicherheitsgebers (11, 111), umfassend
a. eine erste elektrische Versorgungsquelle (15), die mit einem Eingangsanschluss (12) zum Anschluss eines Eingangs des Sicherheitsgebers (11) verbunden ist,
b. eine erste ausgangsseitige Messeinrichtung (18), die mit dem Ausgangsanschluss (13) zum Anschluss eines Ausgangs des Sicherheitsgebers (11) verbunden ist,
c. eine Auswerteanordnung (20), die mit der ersten ausgangsseitigen Messeinrichtung (18) verbunden ist und deren Messsignal erhält, und
d. eine erste eingangsseitige Messeinrichtung (17), die mit dem Eingangsanschluss (12) und der Auswerteanordnung (20) verbunden ist, wobei die Auswerteanordnung (20) das Messsignal der ersten eingangsseitigen Messeinrichtung (17) erhält und eingerichtet ist, die Messsignale auszuwerten,
**dadurch gekennzeichnet, dass**
die Überwachungsanordnung (10, 100, 200) eine Steuereinrichtung (204) umfasst, die dazu eingerichtet ist, eine am Ausgangsschluss (13) messbare elektrische Größe zu beeinflussen und dass die Auswerteanordnung (20) einen Modulationssignalgenerator (24) umfasst, der dazu eingerichtet ist, mit dessen Modulationssignal die Steuereinrichtung (204) anzusteuern.

2. Überwachungsanordnung nach Anspruch 1, **dadurch gekennzeichnet, dass** die Steuereinrichtung (204) mit der Auswerteanordnung (20) verbunden ist und von dieser gesteuert ist.

3. Überwachungsanordnung nach einem der vorhergehenden Ansprüche 1 oder 2, **dadurch gekennzeichnet, dass** die Steuereinrichtung in die Versorgungsquelle (15) integriert ist.

4. Überwachungsanordnung nach einem der Ansprüche 1 oder 2,
**dadurch gekennzeichnet, dass** die Steuereinrichtung (204) einen Widerstand (202) aufweist, der durch einen parallel angeschlossenen Schalter (203) überbrückbar ist.

5. Überwachungsanordnung nach einem der vorhergehenden Ansprüche, **dadurch gekennzeichnet, dass** die Auswerteanordnung (20) einen ersten Mikroprozessor (21) aufweist, der die Messsignale erhält und diese auswertet, oder dass die Auswerteanordnung (20) einen ersten und einen zweiten Mikroprozessor (21, 22) aufweist, die die Messsignale erhalten und diese auswerten.

6. Überwachungsanordnung nach Anspruch 5, **dadurch gekennzeichnet, dass** der erste und der zweite Mikroprozessor (21, 22) datentechnisch, insbesondere über ein Bus-System (23), miteinander verbunden sind und jeder Mikroprozessor (21, 22) das Messsignal einer Messeinrichtung (17, 18) direkt von dieser erhält und das andere Messsignal indirekt über den jeweils anderen Mikroprozessor (21, 22) und die datentechnische Verbindung erhält.

7. Überwachungsanordnung nach einem der vorhergehenden Ansprüche, **dadurch gekennzeichnet, dass** zumindest ein weiterer Eingangsanschluss (112) und ein weiterer Ausgangsanschluss (113) zum Anschluss eines weiteren Sicherheitsgebers (111) vorgesehen sind, wobei der zumindest eine weitere Eingangsanschluss (112) mit einer zweiten elektrischen Versorgungsquelle (116) und einer zweiten eingangsseitigen Messeinrichtung (117) und der zumindest eine weitere Ausgangsanschluss (113) mit einer zweiten ausgangsseitigen Messeinrichtung (118) verbunden ist.

8. Verfahren zur Überwachung eines Sicherheitsgebers (11, 111), mit den Verfahrensschritten:
a. Versorgen eines Eingangsanschlusses des Sicherheitsgebers (11, 111) mit einem elektrischen Versorgungssignal,
b. Messen einer elektrischen Größe am Eingangsanschluss des Sicherheitsgebers (11, 111),
c. Messen einer elektrischen Größe an einem Ausgangsanschluss des Sicherheitsgebers (11, 111),
d. Vergleich der elektrischen Größen oder damit in Beziehung stehender Größen und/oder Vergleich der am Ausgangsanschluss gemessenen Größe oder einer damit in Beziehung stehenden Größe mit einer erwarteten Größe,
e. Bestimmen anhand des Vergleichs, ob der Sicherheitsgeber (11, 111) geöffnet oder geschlossen ist oder ob ein Querschluss vorliegt,
**dadurch gekennzeichnet, dass** eine bei geschlossenem Sicherheitsgeber (11, 111) am Ausgangsanschluss (13) messbare elektrische Größe moduliert wird, insbesondere das Versorgungssignal moduliert wird, vorzugsweise amplituden- oder frequenzmoduliert wird.

9. Verfahren nach Anspruch 8, **dadurch gekennzeichnet, dass** das Versorgungssignal durch eine Stromquelle erzeugt wird, wobei die Stromquelle so angesteuert wird, dass der Strom größer 0A ist und die ausgegebene Spannung bei geschlossenem Sicherheitsgeber unterhalb der Versorgungsspannung (16) liegt.

10. Verfahren nach einem der Ansprüche 8 oder 9, **dadurch gekennzeichnet, dass** als elektrische Größen Spannungen gemessen werden.

11. Verfahren nach Anspruch 10, **dadurch gekennzeichnet, dass** detektiert wird, dass
a. der Sicherheitsgeber (11, 111) geöffnet ist, wenn am Eingangsanschluss des Sicherheitsgebers (11, 111) eine Versorgungsspannung (16, 116) und am Ausgangsanschluss eine Spannung im Bereich von 0V gemessen wird,
b. der Sicherheitsgeber (11, 111) geschlossen ist, wenn die Differenz der am Eingangsanschluss und am Ausgangsanschluss des Sicherheitsgebers (11, 111) gemessenen, insbesondere modulierten, Spannungen kleiner ist als ein vorgegebener erster Wert,
c. ein Querschluss vorliegt, wenn die am Ausgangsanschluss des Sicherheitsgebers (11, 111) gemessene, insbesondere modulierte, Spannung von einer erwarteten Spannung abweicht..

12. Verfahren nach einem der vorhergehenden Ansprüche 8 bis 11, **dadurch gekennzeichnet, dass** die Verfahrensschritte 8.a. - 8.e. für mehrere Sicherheitsgeber (11, 111) durchgeführt werden, wobei für jeden Sicherheitsgeber (11, 111) ein anderes Modulationssignal verwendet wird.

## Claims

1. Monitoring arrangement (10, 100, 200) for monitoring a safety sensor (11, 111) comprising:
a. a first electric power supply source (15) which is connected to an input connection (12) for connecting an input of the safety sensor (11),
b. a first output-side measuring device (18) which is connected to the output connection (13) for connecting an output of the safety sensor (11),
c. an evaluation arrangement (20) which is connected to the first output-side measuring device (18) and which receives the measurement signal thereof, and
d. a first input-side measuring device (17) which is connected to the input connection (12) and the evaluation arrangement (20), wherein the evaluation arrangement (20) receives the measurement signal of the first input-side measuring device (17) and is configured to evaluate the measurement signals,
**characterized in that**
the monitoring arrangement (10, 100, 200) comprises a control device (204) which is configured to influence an electrical variable which can be measured at the output connection (13) and that the evaluation arrangement (20) comprises a modulation signal generator (24) configured to control the control device (204) by means of its modulation signal .

2. Monitoring arrangement according to claim 1, **characterised in that** the control device (204) is connected to the evaluation arrangement (20) and is controlled by it.

3. Monitoring arrangement according to any one of the preceding claims 1 or 2, **characterised in that** the control device is integrated in the power supply source (15).

4. Monitoring arrangement according to any one of claims 1 or 2, **characterised in that** the control device (204) has a resistor (202) which can be bridged by means of a switch (203) which is connected in parallel.

5. Monitoring arrangement according to any one of the preceding claims, **characterised in that** the evaluation arrangement (20) has a first microprocessor (21) which receives the measurement signals and evaluates them, or **in that** the evaluation arrangement (20) has a first microprocessor and a second microprocessor (21, 22) which receive the measurement signals and evaluate them.

6. Monitoring arrangement according to claim 5, **characterised in that** the first and the second microprocessors (21, 22) are connected to each other in technical data terms, in particular via a bus system (23), and each microprocessor (21, 22) receives the measurement signal of a measuring device (17, 18) directly therefrom and receives the other measurement signal indirectly via the respective other microprocessor (21, 22) and the technical data connection.

7. Monitoring arrangement according to any one of the preceding claims, **characterised in that** at least one additional input connection (112) and one additional output connection (113) are provided for connecting an additional safety sensor (111), wherein the at least one additional input connection (112) is connected to a second electric power supply source (116) and a second input-side measuring device (117) and the at least one additional output connection (113) is connected to a second output-side measuring device (118).

8. Method for monitoring a safety sensor (11, 111) having the method steps:
a. supplying an input connection of the safety sensor (11, 111) with an electric power supply signal,
b. measuring an electrical variable at the input connection of the safety sensor (11, 111),
c. measuring an electrical variable at an output connection of the safety sensor (11, 111),
d. comparing the electrical variables or related variables and/or comparing the variable measured at the output connection or a related variable with an anticipated variable,
e. determining on the basis of the comparison whether the safety sensor (11, 111) is open or closed or whether a cross-circuit is present,
**characterized in that** an electrical variable which can be measured at the output connection (13) when the safety sensor (11, 111) is closed is modulated, in particular the power supply signal is modulated, preferably amplitude or frequency-modulated.

9. Method according to claim 8, **characterised in that** the power supply signal is produced by a current source, wherein the current source is controlled in such a manner that the current is greater than 0 A and the voltage output with the safety sensor closed is below the supply voltage (16).

10. Method according to any one of claims 8 or 9, **characterised in that** voltages are measured as electrical variables.

11. Method according to claim 10, **characterised in that** it is detected that
a. the safety sensor (11, 111) is open when at the input connection of the safety sensor (11, 111) a supply voltage (16, 116) and at the output connection a voltage in the region of 0 V are measured,
b. the safety sensor (11, 111) is closed when the difference of the voltages measured, in particular modulated, at the input connection and at the output connection of the safety sensor (11, 111) is smaller than a predetermined first value,
c. a cross-circuit is present when the voltage measured, in particular modulated, at the output connection of the safety sensor (11, 111) deviates from an anticipated voltage.

12. Method according to any one of the preceding claims 8 to 11, **characterised in that** the method steps 8.a. - 8.e. are carried out for a plurality of safety sensors (11, 111), wherein a different modulation signal is used for each safety sensor (11, 111).

## Revendications

1. Ensemble de surveillance (10, 100, 200) conçu pour surveiller un capteur de sécurité (11, 111), comprenant
a. une première source (15) d'alimentation électrique, raccordée à une connexion d'entrée (12) en vue du raccordement d'une entrée du capteur de sécurité (11),
b. un premier dispositif mesureur (18) situé côté sortie, raccordé à la connexion de sortie (13) en vue du raccordement d'une sortie dudit capteur de sécurité (11),
c. un ensemble d'évaluation (20), connecté audit dispositif mesureur (18) situé côté sortie et recevant le signal de mesure de ce dernier, et
d. un premier dispositif mesureur (17) situé côté entrée, raccordé à ladite connexion d'entrée (12) et audit ensemble d'évaluation (20), lequel ensemble d'évaluation (20) reçoit le signal de mesure dudit premier dispositif mesureur (17) situé côté entrée, et est agencé en vue d'évaluer les signaux de mesure, **caractérisé par le fait que**
l'ensemble de surveillance (10, 100, 200) inclut un dispositif de commande (204) agencé en vue d'influencer une grandeur électrique mesurable au niveau de la connexion de sortie (13) ; et **par le fait que** l'ensemble d'évaluation (20) inclut un générateur (24) de signaux de modulation, agencé en vue de piloter ledit dispositif de commande (204) par le signal de modulation dudit générateur.

2. Ensemble de surveillance selon la revendication 1, **caractérisé par le fait que** le dispositif de commande (204) est connecté à l'ensemble d'évaluation (20) et est commandé par celui-ci.

3. Ensemble de surveillance selon l'une des revendications précédentes, **caractérisé par le fait que** le dispositif de commande est intégré dans la source d'alimentation (15).

4. Ensemble de surveillance selon l'une des revendications 1 ou 2, **caractérisé par le fait que** le dispositif de commande (204) comporte une résistance (202) pouvant être court-circuitée par l'intermédiaire d'un interrupteur (203) connecté en parallèle.

5. Ensemble de surveillance selon l'une des revendications précédentes, **caractérisé par le fait que** l'ensemble d'évaluation (20) est muni d'un premier microprocesseur (21) qui reçoit les signaux de mesure et évalue ces derniers ; ou **par le fait que** ledit ensemble d'évaluation (20) est doté de premier et second microprocesseurs (21, 22) qui reçoivent les signaux de mesure et évaluent ces derniers.

6. Ensemble de surveillance selon la revendication 5, **caractérisé par le fait que** les premier et second microprocesseurs (21, 22) sont connectés l'un à l'autre par une technologie informatique, notamment par l'intermédiaire d'un système de bus (23), et chaque microprocesseur (21, 22) reçoit le signal de mesure d'un dispositif mesureur (17, 18), directement en provenance de celui-ci, et reçoit l'autre signal de mesure en mode indirect par l'intermédiaire du microprocesseur (21, 22) respectivement autre, et de la connexion par technologie informatique.

7. Ensemble de surveillance selon l'une des revendications précédentes, **caractérisé par le fait qu'**au moins une connexion supplémentaire d'entrée (112) et une connexion supplémentaire de sortie (113) sont prévues pour le raccordement d'un capteur supplémentaire de sécurité (111), sachant que ladite connexion supplémentaire d'entrée (112), à présence minimale, est raccordée à une seconde source (116) d'alimentation électrique et à un second dispositif mesureur (117) situé côté entrée, et que ladite connexion supplémentaire de sortie (113), à présence minimale, est raccordée à un second dispositif mesureur (118) situé côté sortie.

8. Procédé de surveillance d'un capteur de sécurité (11, 111), incluant les étapes opératoires consistant à :
a. alimenter une connexion d'entrée du capteur de sécurité (11, 111) en un signal d'alimentation électrique,
b. mesurer une grandeur électrique au niveau de ladite connexion d'entrée du capteur de sécurité (11, 111),
c. mesurer une grandeur électrique au niveau d'une connexion de sortie dudit capteur de sécurité (11, 111),
d. comparer, à une grandeur escomptée, les grandeurs électriques ou des grandeurs corrélatives de ces dernières, et/ou la grandeur mesurée au niveau de la connexion de sortie, ou une grandeur corrélative,
e. déterminer, à l'appui de la comparaison, si le capteur de sécurité (11, 111) est ouvert ou fermé, ou bien s'il règne un court-circuit transversal,
**caractérisé par** la modulation d'une grandeur électrique mesurable au niveau de la connexion de sortie (13) à l'état fermé du capteur de sécurité (11, 111), notamment par une modulation du signal d'alimentation, de préférence une modulation en amplitude ou en fréquence.

9. Procédé selon la revendication 8, **caractérisé par le fait que** le signal d'alimentation est engendré par une source de courant, laquelle source de courant est pilotée de façon telle que le courant soit supérieur à 0 A, et que la tension délivrée se situe en deçà de la tenson d'alimentation (16) à l'état fermé du capteur de sécurité.

10. Procédé selon l'une des revendications 8 ou 9, **caractérisé par le fait que** des tensions sont mesurées en tant que grandeurs électriques.

11. Procédé selon la revendication 10, **caractérisé par le fait qu'**il est détecté
a. que le capteur de sécurité (11, 111) est ouvert lorsqu'une tension d'alimentation (16, 116), et une tension située dans la plage de 0 V, sont respectivement mesurées au niveau de la connexion d'entrée dudit capteur de sécurité (11, 111), et au niveau de la connexion de sortie,
b. que ledit capteur de sécurité (11, 111) est fermé lorsque la différence, entre les tensions notamment modulées qui sont mesurées aux niveaux de ladite connexion d'entrée et de ladite connexion de sortie dudit capteur de sécurité (11, 111), est plus petite qu'une première valeur préétablie,
c. qu'il règne un court-circuit transversal lorsque la tension notamment modulée, mesurée au niveau de ladite connexion de sortie dudit capteur de sécurité (11, 111), s'écarte d'une tension escomptée.

12. Procédé selon l'une des revendications 8 à 11 précédentes, **caractérisé par le fait que** les étapes opératoires 8.a.-8.e. sont exécutées pour plusieurs capteurs de sécurité (11, 111), un signal de modulation autre étant utilisé pour chaque capteur de sécurité (11, 111).
